Europäisches Patentamt

European Patent Office

Office européen des brevets

(11) Veröffentlichungsnummer: **0 456 891 A1**

## EUROPÄISCHE PATENTANMELDUNG

(21) Anmeldenummer: 90122827.0

(51) Int. Cl.⁵: **C23C 14/34**, H01J 37/34

(22) Anmeldetag: **29.11.90**

(30) Priorität: **14.05.90 DE 4015388**

(43) Veröffentlichungstag der Anmeldung:
**21.11.91 Patentblatt 91/47**

(84) Benannte Vertragsstaaten:
**BE DE FR GB IT LU**

(71) Anmelder: **LEYBOLD AKTIENGESELLSCHAFT**
**Wilhelm-Rohn-Strasse 25**
**W-6450 Hanau am Main 1(DE)**

(72) Erfinder: **Hartig, Klaus, Dr.**
**Hanauer Strasse 17**
**W-6451 Ronneburg 2(DE)**
Erfinder: **Szczyrbowski, Joachim, Dr.**
**Ringofenstrasse 5**
**W-8758 Goldbach(DE)**

(54) **Kathodenzerstäubungsvorrichtung.**

(57) Kathodenzerstäubungsvorrichtung mit hoher Zerstäubungsrate, mit einer Katode, die aus einem Kathodengrundkörper (1) und einem parallel dazu angeordneten Target (6) besteht und versehen ist mit von einem Kühlmittel durchflossenen Kanal (5) im Kathodengrundkörper (1), wobei der Kanal (5) von einer dünnwandigen, als Membran ausgebildeten Wand (2) gegenüber dem zu kühlenden Target (6) abgegrenzt ist und die Wand (2) große Kontaktflächen mit gutem Wärmeübergang zu der Targetoberfläche aufweist und die Kontaktfläche zwischen dem Target (6) und der Wand (2) mit einem Werkstoff niedriger Sputterrate wie z. B. einer Graphitschicht (4) beschichtet ist, um ein Durchsputtern so lange wie möglich zu verzögern.

# FIG.1

EP 0 456 891 A1

Die Erfindung betrifft eine Kathodenzerstäubungsvorrichtung mit hoher Zerstäubungsrate, mit einer Kathode, die aus einem Kathodengrundkörper und einem parallel dazu angeordneten Target besteht und versehen ist mit von einem Kühlmittel durchflossenen Kanälen im Kathodengrundkörper, wobei die Kanäle von einer dünnwandigen Wand gegenüber dem zu kühlenden Target abgegrenzt sind und die Wand große Kontaktflächen mit gutem Wärmeübergang zu der Targetoberfläche aufweist.

Allgemein bekannt sind Kathodenzerstäubungsvorrichtungen mit hoher Zerstäubungsrate, bei denen die Wärmeübertragung nach dem Prinzip der Direktkühlung des Targets oder durch Verbinden des Targets mit einer gekühlten Trägerplatte erfolgt.

Bekannt ist weiterhin eine Kathodenzerstäubungsvorrichtung (P 39 37 558.7), bei der in die in einer Tragplatte angeordneten Kühlkanäle vom Kühlmittel durchflossene dünnwandige Rohre eingelegt sind, deren Querschnittsprofile den Querschnittsprofilen der Kühlkanäle entsprechen, so daß die Rohre mit ihren Außenwänden den Kontakt mit den Innenflächen der Kühlkanäle bzw. mit der Außenfläche der Kathode haben.

Nachteilig bei diesen bekannten Vorrichtungen sind insbesondere ungünstige Kühlmittel-(z.B. Wasser-)Vakuumdichtungen oder ein konstruktionsbedingt unzureichender Kontakt mit der gekühlten Trägerplatte zum Target. Bei Einsatz der Vorrichtung mit den vom Kühlmittel durchflossenen dünnwandigen Rohren besteht der Nachteil, daß es zum Durchsputtern des Targets kommt und aufgrund der geringen Materialstärke der Kühlrohre bzw. der den Kühlkanal begrenzenden Wand auch sofort zum Durchsputtern der Rohrwand führt. Anschließend folgt zwangsläufig ein Einbruch des in dem Kühlrohr geführten Kühlmittels (Wasser) in das Innere der die Kathodenzerstäubungsvorrichtung umgebenden Vakuumkammer, die hier nicht näher beschrieben ist. Dies bedingt einen Stillstand der Gesamtanlage mit anschließenden Instandsetzungsarbeiten, die immer mit erheblichen Kosten verbunden sind.

Der vorliegenden Erfindung liegt nun die Aufgabe zugrunde, eine Kathodenzerstäubungsvorrichtung so zu verbessern, daß ein Durchsputtern der kühlmittelführenden bzw. -begrenzenden Rohre bzw. Wände so lange wie möglich verzögert und damit ein anschließender Kühlmitteleinbruch vermieden wird.

Diese Aufgabe wird erfindungsgemäß dadurch gelöst, daß die Kontaktfläche zwischen dem Target und der Wand mit einem Werkstoff niedriger Sputterrate beschichtet ist.

Mit Vorteil wird durch das Beschichten der Kontaktfläche - mit z. B. Graphit - die Zeitspanne bis zum Durchsputtern der Wand (Membran) erheblich verlängert und der Wärmeübergang vom Target zum Kühlmittel möglicherweise noch verbessert.

Zweckmäßigerweise wird die auf zubringende Schicht, wie z. B. UHV-verträgliches Graphit, durch Aufsprühen aus einer käuflichen Sprühdose aufgetragen und kann später beliebig oft nachgebessert werden.

Vorteilhaft ist weiterhin, daß die den Kühlkanal begrenzende dünnwandige Wand nach Art einer Membran verformbar ist und sich beim Druckaufbau des Kühlmittels satt an die ihr zugekehrte Targetfläche anlegt und somit einen hervorragenden Wärmeübergang zwischen Target und Kühlmittel ermöglicht.

Die Erfindung läßt die verschiedensten Ausführungsmöglichkeiten zu; zwei davon sind in den anhängenden Zeichnungen näher dargestellt, und zwar zeigen:

Fig. 1     einen Teilschnitt durch eine Kathode mit Kühlmembran und

Fig. 2     einen Teilschnitt durch eine Kathode mit einem Kühlrohr.

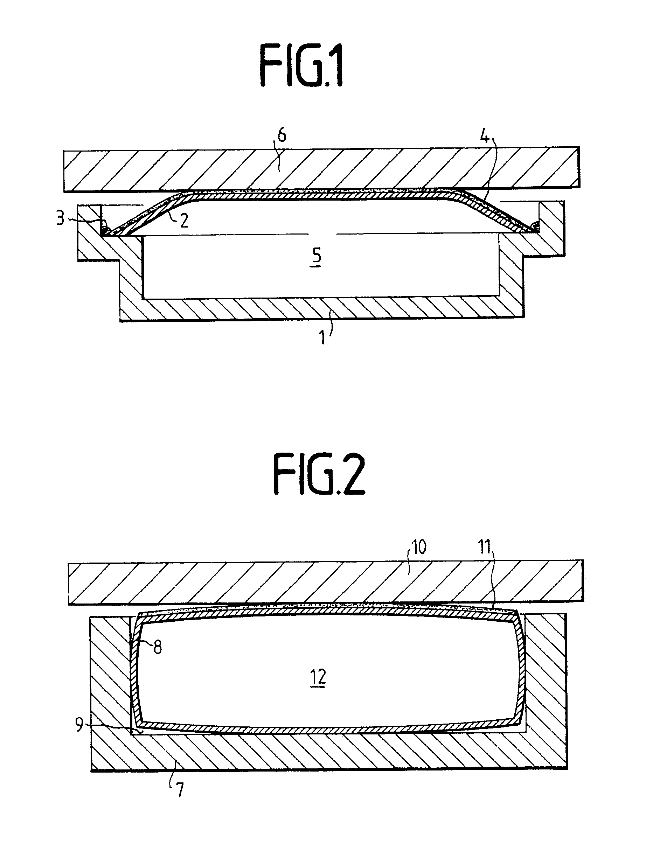

Die Innenfläche eines wannenförmigen Kathodengrundkörpers 1 vorzugsweise aus rostfreiem Stahl, weist einen spiegelsymmetrischen, stufenförmigen Verlauf auf. Auf den beiden sich gegenüberliegenden und in horizontaler Richtung erstreckenden oberen Stufen des Kathodengrundkörpers 1 ist eine dünnwandige, flexible Membran 2, vorzugsweise ebenso aus rostfreiem Stahl, so angeordnet, daß sie mit einer definierten, nach oben gerichteten Wölbung die beiden außenliegenden senkrechten Enden des Kathodengrundkörpers 1 überragt. Die Membran 2 ist an ihren äußeren Enden durch die Schweißnaht 3 mit dem Grundkörper 1 vakuumdicht verbunden. Die nach oben gerichtete äußere Seite der Membran ist mit einer Graphitschicht 4 versehen. Der von den Innenflächen des Grundkörpers 1 und der Membran 2 gebildete Kanal 5 ist von Kühlwasser durchströmt. Durch den Überdruck des in dem Kanal 5 strömenden Kühlmittels, gegenüber der Umgebung, wird die flexible Membran 2 mit ihrer graphitbeschichteten Außenseite 4 gegen die Unterseite eines in einem definierten Abstand parallel und oberhalb des Kathodengrundkörpers 1 angeordneten ebenen Targets 6 angedrückt (Figur 1).

Wie Figur 2 zeigt, ist in dem von einem U-förmigen Kathodengrundkörper 7 gebildeten Kanal 9 ein dünnwandiges, flexibles Kühlrohr 8, vorzugsweise aus rostfreiem Stahl, mit etwa rechteckigem Querschnitt so eingelegt, daß jeweils die drei Außenflächen des Kühlrohrs 8 an den Innenflächen des Kanals 9 überwiegend anliegen. Die obere, dem Target 10 zugewandte Seite des Rohrs 8 ist außen mit einer Graphitschicht 11 versehen und wird durch das im Innern des Rohrs 8 strömende Kühlwasser 12 an die Unterseite eines in definiertem Abstand zu dem Kathodengrundkörper 7 angeordneten ebenen Targets 10 angedrückt.

## Auflistung der Einzelteile

| | |
|---|---|
| 1 | Kathodengrundkörper |
| 2 | Wand, Membran |
| 3 | Schweißnaht |
| 4 | Graphitschicht, C-Schicht |
| 5 | Kanal |
| 6 | Target |
| 7 | Kathodengrundkörper |
| 8 | Kühlrohr (Wand) |
| 9 | Kanal |
| 10 | Target |
| 11 | Graphitschicht, C-Schicht |
| 12 | Kühlmittel |

## Erläuterung

UHV = Ultrahochvakuum

## Patentansprüche

1. Kathodenzerstäugungsvorrichtung mit hoher Zerstäubungsrate, mit einer Kathode, die aus einem Kathodengrundkörper (1, 7) und einem parallel dazu angeordnetem Target (6, 10) besteht und versehen ist mit von einem Kühlmittel (12) durchflossenen Kanälen (5, 9) im Kathodengrundkörper (1, 7), wobei die Kanäle (5, 9) von einer dünnwandigen Wand (2, 8) gegenüber dem zu kühlenden Target (6, 10) abgegrenzt sind und die Wand (2, 8) große Kontaktflächen mit gutem Wärmeübergang zu der Targetoberfläche aufweist, *dadurch gekennzeichnet,* daß die Kontaktfläche zwischen dem Target (6, 10) und der Wand (2, 8) mit einem Werkstoff niedriger Sputterrate beschichtet ist.

2. Kathodenzerstäubungsvorrichtung nach Anspruch 1, *dadurch gekennzeichnet,* daß die Wand (2, 8) aus einem Blechzuschnitt gebildet ist und mit ihren Rändern fest mit dem Grundkörper (1, 7) vakuumdicht verbunden, beispielsweise verschweißt, verlötet oder verklebt ist, wobei die Wand (2, 8) nach Art einer Membran verformbar ist und sich beim Druckaufbau satt an die ihr zugekehrte Targetfläche anlegt.

3. Kathodenzerstäubungsvorrichtung nach Anspruch 1 oder 2, *dadurch gekennzeichnet,* daß die der Wand (2, 8) zugewandte Seite des Targets (6, 10) beschichtet ist.

4. Kathodenzerstäubungsvorrichtung nach Anspruch 1 oder 2, *dadurch gekennzeichnet,* daß die dem Target (6, 10) zugewandte Seite der Wand (2, 8) beschichtet ist.

5. Kathodenzerstäubungsvorrichtung nach einem oder mehreren der Ansprüche, *dadurch gekennzeichnet,* daß als Werkstoff für die Beschichtung vorzugsweise Graphit verwendet ist.

# FIG.1

# FIG.2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| P,Y | EP-A-0 393 344 (BALZERS AKTIENGESELL-SCHAFT)Oktober 1990 <br> * Spalte 1, Zeile 31 - Spalte 2, Zeile 48; Abbildungen 1-3 * <br> — — — | 1-5 | C 23 C 14/34 <br> H 01 J 37/34 |
| Y | PATENT ABSTRACTS OF JAPAN vol. 12, no. 263 (C-514)(3110) 22. Juli 1988 <br> & JP-A-63 45 368 (TOSHIBA CORP ) 26. Februar 1988 <br> * das ganze Dokument * <br> — — — — — | 1-5 |  |

| | RECHERCHIERTE SACHGEBIETE (Int. Cl.5) |
|---|---|
| | C 23 C |

Der vorliegende Recherchenbericht wurde für alle Patentansprüche erstellt

| Recherchenort | Abschlußdatum der Recherche | Prüfer |
|---|---|---|
| Den Haag | 05 August 91 | EKHULT H.U. |